# EUROPEAN PATENT APPLICATION

(11) **EP 1 494 230 A2**
(43) Date of publication of application: **05.01.2005**
(21) Application number: 04015653.1
(22) Date of filing: 02.07.2004
(51) Int. Cl.: G11B 7/24

(54) **Phase change recording film having high electrical resistance and sputtering target for forming phase change recording film**

(30) Priority: 03.07.2003 JP 2003190746; 03.10.2003 JP 2003345360; 03.10.2003 JP 2003345361
(71) Applicant: MITSUBISHI MATERIALS CORPORATION, Chiyoda-ku, Tokyo (JP)
(72) Inventor: Nonaka, Sohei, 12-6, Techno-Park Sanda-shi Hyogo (JP)
(74) Representative: HOFFMANN - EITLE

(57) **Abstract**

The present invention relates to a phase change recording film having high electrical resistance, wherein the phase change recording film has a composition comprising, by atom% (hereinafter, % means atom%): 15 to 30% of Ge; 15 to 25% of Sb; a total of 0.1 to 13% of one or two elements selected from the group consisting essentially of Al and Si; and the balance of Te and inevitable impurities.

Furthermore, the present invention relates to a phase change recording film having high electrical resistance, wherein the phase change recording film has a composition comprising, by atom%: 15 to 30% of Ge; 15 to 30% of Sb; 0.2 to 8% of C; and the balance of Te and inevitable impurities,
or 15 to 30% of Ge; 15 to 30% of Sb; 0.2 to 12% of B; and the balance of Te and inevitable impurities,
or 15 to 30% of Ge; 15 to 30% of Sb; a total of 0.1 to 10% of at least one or two elements selected from the group consisiting essentially of Ce, Pr, Nd, Pm, Sm, Eu, Gd, Tb, Dy, Ho, Er, Tm, Yb and Lu; and the balance of Te and inevitable impurities.

The present invention also relates to a sputtering target for forming the phase change recording film.

## Description

### BACKGROUND OF THE INVENTION

### 1. Field of the Invention

The present invention relates to a phase change recording film having high electrical resistance and a sputtering target for forming the phase change recording film.

### 2. Description of the Related Art

Generally, a Ge-Sb-Te system recording material is used for a phase change recording layer for a phase change memory (Phase Change RAM which is a kind of a semiconductor non-volatile memory). In this phase change recording layer, a crystalline phase change material is used, and a part of the phase change material is rapidly heated and melted by a heater, thereby carrying out rewriting. That is, the phase change material is rapidly cooled and then is made partially amorphous, or an amorphous substance of the phase change material is kept at the temperature that is over its crystallization temperature and below its melting point to return it to a crystalline state, thereby carrying out rewriting. Thus, reading is performed by means of a difference between the electric resistance of the crystalline phase change material, and that of the partially amorphous phase change material. It is known that this phase change recording layer is formed by sputtering using a target comprising alloys having the composition to be a phase change recording layer (for example, referred to Patent documents 1 to 3, Non-patent document 1 and 2).

### [Patent document 1]

JP 2001-502848 bulletin

### [Patent document 2]

JP 2002-512439 bulletin

### [Patent document 3]

JP 2002-540605 bulletin

### [Non-patent document 1]

"A monthly publication of The Japan Society of Applied Physics" Vol. 71, No.12 (2002) Page 1513-1517

### [Non-patent document 2]

"Nikkei Micro-devices" March, 2002 Page 70-78

However, mentioned in Non-patent document 1, a conventional phase change recording film still has a problem to be realized in micro-fabrication, because of the large electric current in a circuit at the time of writing and erasing, which consequently increases the power consumption. As such, these reasons collectively put a burden on a circuit.
Thus, a phase change memory chip having a small electric current at the time of writing and erasing operation is under development to be utilized in a phase change recording layer which requires a small electric current at the time of writing and erasing operation.

### SUMMARY OF THE INVENTION

Thus, the present inventors have studied to decrease the electric current at the time of writing and erasing operation, by increasing the electrical resistance of a phase change recording film.

As a result, in a Ge-Sb-Te system phase change recording film, a phase change recording film containing, by atom% (hereinafter, % means atom%), a total of 0.1 to 13% of one or two elements selected from the group consisting essentially of Al and Si has a high electrical resistance in a crystalline state, and by means of the improvement, which makes it possible to reduce the electric current at the time of writing and erasing operation.

A study showed that a Ge-Sb-Te system phase change recording film containing a total of 0.1 to 13% of one or two elements selected from the group consisting essentially of Al and Si can be obtained by sputtering using a Ge-Sb-Te system target containing a total of 0.1 to 13% of one or two elements selected from the group consisting essentially of Al and Si.

The present invention, which is made based on the study result, provides (1) a phase change recording film having high electrical resistance, wherein the phase change recording film has a composition comprising, by atom% (hereinafter, % means atom%): 15 to 30% of Ge; 15 to 25% of Sb; a total of 0.1 to 13% of one or two elements selected from the group consisting essentially of Al and Si; and the balance of Te and inevitable impurities, (2) a sputtering target for forming the phase change recording film having high electrical resistance described in (1), wherein the phase change recording film has a composition comprising: 15 to 30% of Ge; 15 to 25% of Sb; a total of 0.1 to 13% of one or two elements selected from the group consisting essentially of Al and Si; and the balance of Te and inevitable impurities.

Further, in a Ge-Sb-Te system phase change recording film, a phase change recording film containing 0.2 to 8% of C(carbon) by atom% (hereinafter, % means atom%) has high electrical resistance in a crystalline state, which makes it possible to reduce the electric current at the time of writing and erasing operation.

A study showed that a Ge-Sb-Te system phase change recording film containing 0.2 to 8% of C(carbon) could be obtained by sputtering using a Ge-Sb-Te system target containing 0.2 to 8% of C(carbon).

Therefore, the present invention provides a phase change recording film having high electrical resistance, wherein the phase change recording film has a composition comprising, by atom% (hereinafter, % means atom%): 15 to 30% of Ge; 15 to 30% of Sb; 0.2 to 8% of C(carbon); and the balance of Te and inevitable impurities, and a sputtering target for forming the phase change recording film-having high electrical resistance, wherein the phase change recording film has a composition comprising: 15 to 30% of Ge; 15 to 30% of Sb; 0.2 to 8% of C(carbon); and the balance of Te and inevitable impurities.

Further, in a Ge-Sb-Te system phase change recording film, a phase change recording film containing 0.2 to 12% of B(boron) by atom% (hereinafter, % means atom%) has high electrical resistance in a crystalline state, which makes it possible to reduce the electric current at the time of writing and erasing operation.

A study showed that a Ge-Sb-Te system phase change recording film containing 0.2 to 12% of B(boron) could be obtained by sputtering using a Ge-Sb-Te system target containing 0.2 to 12% of B(boron).

Therefore, the present invention provides a phase change recording film having high electrical resistance, wherein the phase change recording film has a composition comprising, by atom% (hereinafter, % means atom%): 15 to 30% of Ge; 15 to 30% of Sb; 0.2 to 12% of B(boron); and the balance of Te and inevitable impurities, and a sputtering target for forming the phase change recording film having high electrical resistance described (1), wherein the phase change recording film has a composition comprising: 15 to 30% of Ge; 15 to 30% of Sb; 0.2 to 12% of B(boron); and the balance of Te and inevitable impurities.

Further, a study showed that a sputtering target utilized to form a Ge-Sb-Te system phase change recording film containing a lanthanoid element that has a larger atomic weight than La, selected from lanthanoid elements having the similar property as La, is stronger in mechanical strength. As a result, the film showed a stronger resistance against crack during sputtering, and exhibited less number of arcing. A sputtering target including Ce, Pr, Nd, Pm, Sm, Eu, Gd, Tb, Dy, Ho, Er, Tm, Yb and Lu rather than La is better in mechanical strength, and stronger against crack during sputtering, and showed less number of arcing.

The present invention, which is made based on the study result, provides a sputtering target for forming the phase change recording film having high electrical resistance, wherein the phase change recording film has a composition comprising: 15 to 30% of Ge; 15 to 30% of Sb; a total of 0.1 to 10% of at least one or two elements selected from the group consisting essentially of Ce, Pr, Nd, Pm, Sm, Eu, Gd, Tb, Dy, Ho, Er, Tm, Yb and Lu, and the balance of Te and inevitable impurities.

When sputtering is performed using a sputtering target for forming the phase change recording film described above, a phase change recording film having high electrical resistance can be obtained wherein the film has a composition comprising: 15 to 30% of Ge; 15 to 30% of Sb; a total of 0.1 to 10% of at least one or two elements selected from the group consisting essentially of Ce, Pr, Nd, Pm, Sm, Eu, Gd, Tb, Dy, Ho, Er, Tm, Yb and Lu, and the balance of Te and inevitable impurities.

Therefore, the present invention provides a phase change recording film having high electrical resistance, wherein the phase change recording film has a composition comprising: 15 to 30% of Ge; 15 to 30% of Sb; a total of 0.1 to 10% of at least one or two elements selected from the group consisting essentially of Ce, Pr, Nd, Pm, Sm, Eu, Gd, Tb, Dy, Ho, Er, Tm, Yb and Lu; and the balance of Te and inevitable impurities.

Herein below, the reason why the composition of a sputtering target for forming a phase change recording film according to the present invention, and a phase change recording film having high electrical resistance that is formed using the sputtering target is limited as described above, will be explained.

### (a) Al and Si

If the content of these elements contained in a phase change recording film is less than 0.1%, it is not preferable because the resistance value of the film does not significantly increase. On the other hand, if the content exceeds 13%, it is also not preferable because the crystallization temperature rises too high. Hence, the total content of one or two elements selected from the group consisting essentially of Al and Si is set to about 0.1 to 13%.

If the crystallization temperature rises suitably, it can be expected that the stability of amorphous state increases and retention characteristics be improved in case that the film is used as a memory. However, if the temperature is too high, crystallization becomes difficult. Therefore, the total content of one or two elements selected from the group of consisting essentially of Al and Si is more preferably set to about 1 to 10% (more preferably set to about 1 to 8%).

### (b) C(carbon)

If the content of carbon element contained in a phase change recording film is less than 0.2%, it is not preferable because the resistance value of the film does not significantly increase. On the other hand, if the content exceeds 8%, it is also not preferable because the crystallization temperature rises too high. Hence, the total content of carbon element is set to about 0.2 to 8%.

If the crystallization temperature rises suitably, it can be expected that the stability of amorphous state increases and retention characteristics be improved in case that the film is used as a memory. However, if the temperature is too high, crystallization becomes difficult. Therefore, the total content of C(carbon) element is more preferably set to about 0.5 to 6%.

### (c) B(boron)

If the crystallization temperature rises suitably, it can be expected that the stability of amorphous state increases and retention characteristics be improved in case that the film is used as a memory. However, if the temperature is too high, crystallization becomes difficult. From the reasons described above, if the content of boron element contained in a phase change recording film is less than 0.2%, it is not preferable because the resistance value of the film does not significantly increase. On the other hand, if the content exceeds 12%, it is also not preferable because the crystallization temperature rises too high. Hence, the content of boron element contained in the phase change recording film of the present invention is set to about 0.2 to 12%. The content of boron element contained in the phase change recording film of the present invention is more preferably set to about 1.0 to 10.0%.

(d) At least one or two elements selected from the group consisting essentially of Ce, Pr, Nd, Pm, Sm, Eu, Gd, Tb, Dy, Ho, Er, Tm, Yb and Lu:

If other lanthanoid element including La is added to a phase change recording film, the resistance value of the phase change recording film increase. However, if Ce, Pr, Nd, Pm, Sm, Eu, Gd, Tb, Dy, Ho, Er, Tm, Yb and Lu rather than La is added to a sputtering target for forming a phase change recording film, the mechanical strength increases, the crack during sputtering decreases, and particles are less generated. Thus, at least one or two elements selected from the group consisting essentially of Ce, Pr, Nd, Pm, Sm, Eu, Gd, Tb, Dy, Ho, Er, Tm, Yb and Lu is and/or are added to a sputtering target for forming the Ge-Sb-Te system phase change recording film according to the present invention. However, if the content of elements contained in a phase change recording film is less than 0.1%, it is not preferable because the resistance value of the film does not significantly increase. On the other hand, if the content exceeds 10%, it is also not preferable because the crystallization temperature rises too high.

Hence, the total content of at least one or two elements selected from the group consisting essentially of Ce, Pr, Nd, Pm, Sm, Eu, Gd, Tb, Dy, Ho, Er, Tm, Yb and Lu included in a sputtering target for forming a phase change recording film of the present invention is set to about 0.1 to 10%. The content of these elements is more preferably set to about 1 to 8%.

In addition, setting the total content of at least one or two elements selected from the group consisting essentially of Ce, Pr, Nd, Pm, Sm, Eu, Gd, Tb, Dy, Ho, Er, Tm, Yb and Lu, to about 0.1 to 10%, is based on the following reasons. That is, the optimized rising of crystallization temperature in a phase change recording film means the stabilization of amorphous state, and a memory having excellent retention characteristics for a long time can be obtained. However, if the total content of at least one two elements selected from the group consisting essentially of Ce, Pr, Nd, Pm, Sm, Eu, Gd, Tb, Dy, Ho, Er, Tm, Yb and Lu is less than 0.1%, the crystallization temperature does not rises optimally. On the other hand, if the total content of an element(s) exceeds 10%, the temperature for crystallization is so high that a large amount of electricity is required for rewriting in a memory, which is not preferable from the viewpoint of low power consumption.

### (e) Ge and Sb

It is preferable that Ge and Sb in the phase change recording film having high electrical resistance included Al and/or Si are in a range of 15 to 30% of Ge and 15 to 25% of Sb. Setting the range like that is based on the following reasons. That is, if the content of Ge is less than 15 % or the content of Sb is less than 15 %, and if the content of Ge exceeds 30% or the content of Sb exceeds 25%, the resistance value decreases, and the time required for crystallization becomes long, which is not preferable.

It is preferable that Ge and Sb in the phase change recording film having high electrical resistance incuded C(carbon), B(boron) or At least one or two elements selected from the group consisting essentially of Ce, Pr, Nd, Pm, Sm, Eu, Gd, Tb, Dy, Ho, Er, Tm, Yb and Lu are in a range of 15 to 30% of Ge and 15 to 30% of Sb. Setting the range like that is based on the following reasons. That is, if the content of Ge is less than 15 % or the content of Sb is less than 15 %, and if the content of Ge exceeds 30% or the content of Sb exceeds 30%, the resistance value decreases, and the time required for crystallization becomes long, which is not preferable.

The content of Ge and Sb are more preferably set to about 17 to 25% of Ge, about 17 to 23% of Sb. In the phase change recording film having high electrical resistance according to the present invention, it is preferable that the specific resistance value measured by the four point probe method after crystallization be more than 5x10⁻² Ω·cm (it is more preferable that the specific resistance value be not less than 8x10⁻² Ω·cm). The reason is as follows. If the specific resistance value is less than 5x10⁻² Ω·cm, a large amount of electric current in a circuit, the power consumption becomes large, and a problem to be realized in micro-fabrication occurs, which are not preferable. Further, the specific resistance of a Ge-Sb-Te alloy in an amorphous state is about 1x 10³ Ω·cm, and it is preferable for stable reading that the difference between the specific resistance values of a phase change recording film in a crystalline state and an amorphous state is at least one and half order. Therefore, it is necessary that the specific resistance value of a phase change recording film in the crystallized state is less than 5x10¹ Ω·cm. Thus, the specific resistance value measured by the four point probe method after crystallization of the phase change recording film according to the present invention is set to 5x10⁻² to 5x10¹ Ω·cm.

A sputtering target for forming a phase change recording film according to the present invention is prepared by a method comprising the steps of: melting an alloy having the same composition as the phase change recording film according to the present invention in an Ar gas atmosphere; tapping the melt into an iron mold to form an alloy ingot; pulverizing the ingot into alloy powder in an inert gas atmosphere; and finally hot-pressing the alloy powder in vacuum. More, it is also possible to make a sputter target by hot-pressing a powder mixed a Ge-Sb-Te alloy powder and a powder of Al, Si, C, B, Ce, Pr, Nd, Pm, Sm, Eu, Gd, Tb, Dy, Ho, Er, Tm, Yb and Lu. The hot pressing in vacuum is performed under a pressure of 15 to 155 Mpa at a temperature of 370 to 580°C for one or two hours. It is more preferable that, when the temperature of the mold falls down to 270 to 300°C, it is cooled at normal temperature at a cooling rate of 1 to 3°C/min.

### DESCRIPTION OF THE PREFERRED EMBODIMENT

### Example 1

Ge, Sb, Te and Al and/or Si were melted in an Ar gas atmosphere, and the melt was cast to make an alloy ingot. Thereafter, the ingot was crushed into alloy powder in an Ar atmosphere, having a particle size less than or equal to 250 µm.

The alloy powder was hot-pressed in vacuum under a pressure of 146 Mpa at a temperature of 400°C to form a hot pressed body. The hot pressed body was ground by a cemented carbide bit at 200 rpm lathe revolution to obtain a disc having 125 mm in diameter and 5 mm in thickness. Targets 1 to 36 according to the present invention, comparative targets 1 to 10 and a conventional target 1; were prepared in this manner and the composition is shown in Table 1.

**[Table 1]**

| Target | | Composition (atom%) | | | | |
|---|---|---|---|---|---|---|
| | | Ge | Sb | Al | Si | Te |
| The present invention | 1 | 21.98 | 21.98 | 0.15 | - | Balance |
| | 2 | 21.96 | 21.96 | 0.2 | - | Balance |
| | 3 | 21.89 | 21.89 | 0.5 | - | Balance |
| | 4 | 21.78 | 21.78 | 1.0 | - | Balance |
| | 5 | 21.56 | 21.56 | 2.0 | - | Balance |
| | 6 | 21.34 | 21.34 | 3.0 | - | Balance |
| | 7 | 21.12 | 21.12 | 4.0 | - | Balance |
| | 8 | 21.98 | 21.98 | - | 0.15 | Balance |
| | 9 | 21.96 | 21.96 | - | 0.2 | Balance |
| | 10 | 21.89 | 21.89 | - | 0.5 | Balance |
| | 11 | 21.78 | 21.78 | - | 1.0 | Balance |
| | 12 | 21.56 | 21.56 | - | 2.0 | Balance |
| | 13 | 21.34 | 21.34 | - | 3.0 | Balance |
| | 14 | 21.12 | 21.12 | - | 4.0 | Balance |
| | 15 | 21.34 | 21.34 | 1.0 | 2.0 | Balance |
| | 16 | 21.34 | 21.34 | 2.0 | 1.0 | Balance |
| | 17 | 21.09 | 21.09 | 4.8 | - | Balance |
| | 18 | 20.65 | 20.65 | 6.7 | - | Balance |
| | 19 | 20.42 | 20.42 | 8.2 | - | Balance |
| | 20 | 19.98 | 19.98 | 9.8 | - | Balance |
| | 21 | 19.78 | 19.78 | 11.2 | - | Balance |
| | 22 | 19.31 | 19.31 | 12.9 | - | Balance |
| | 23 | 21.09 | 21.09 | - | 4.9 | Balance |
| | 24 | 20.87 | 20.87 | - | 5.6 | Balance |
| | 25 | 21.98 | 21.98 | - | 6.6 | Balance |
| | 26 | 21.96 | 21.96 | - | 7.9 | Balance |
| | 27 | 21.89 | 21.89 | - | 8.4 | Balance |
| | 28 | 21.78 | 21.78 | - | 9.1 | Balance |
| | 29 | 21.56 | 21.56 | - | 10.8 | Balance |
| | 30 | 21.34 | 21.34 | - | 12.6 | Balance |
| | 31 | 21.12 | 21.12 | 0.5 | 0.2 | Balance |
| | 32 | 21.98 | 21.98 | 1.3 | 0.2 | Balance |
| | 33 | 21.96 | 21.96 | 0.9 | 4.5 | Balance |
| | 34 | 21.89 | 21.89 | 5.8 | 1.0 | Balance |
| | 35 | 21.78 | 21.78 | 3.6 | 6.2 | Balance |
| | 36 | 21.56 | 21.56 | 8.1 | 4.0 | Balance |
| Comparative | 1 | 21.99 | 21.99 | 0.05* | - | Balance |
| | 2 | 18.87 | 18.87 | 15* | - | Balance |
| | 3 | 21.99 | 21.99 | - | 0.05* | Balance |
| | 4 | 18.87 | 18.87 | - | 15* | Balance |
| | 5 | 14.11* | 24.80 | 10 | - | Balance |
| | 6 | 31.23* | 20.45 | - | 10 | Balance |
| | 7 | 23.50 | 14.10* | 3.0 | 5.0 | Balance |
| | 8 | 19.70 | 26.3* | 6.0 | 1.0 | Balance |
| Conventional 1 | | 22.20 | 22.20 | - | - | Balance |

| | | | | | | |
|---|---|---|---|---|---|---|
| * mark means that the value deviates from the conditions of the present invention. | | | | | | |

Each of targets 1 to 36 according to the present invention, comparative targets 1 to 10 and conventional target 1, was bonded to a backing plate for cooling made of copper with an indium bonding material of purity: 99.999 weight %, which was loaded into a direct current magnetron sputtering apparatus, and the distance between a target and a substrate (an Si wafer formed with SiO₂ having 100 nm in thickness on the surface thereof) is set to be 70 mm. After vacuumizing was performed to reach an ultimate pressure of less than or equal to 5x10⁻⁵ Pa, an Ar gas was supplied to be a total pressure of 1.0 Pa. Under the conditions of
Substrate temperature: room temperature,
Power input: 50 W (0.4 W/cm²),
sputtering was carried out to obtain the phase change recording films 1 to 36 according to the present invention, the comparative phase change recording films 1 to 8 and the conventional phase change recording film 1 having the same thickness of 300 nm on the surface of the substrate.

The composition of the phase change recording films 1 to 36 according to the present invention, the comparative phase change recording films 1 to 8 and the conventional phase change recording film 1 were measured by ICP (inductively coupled plasma method), and the results are shown in Table 2. In addition, after the phase change recording films 1 to 36 according to the present invention, the comparative phase change recording films 1 to 8 and the conventional phase change recording film 1, were kept for crystallization at a temperature of 300°C for 5 minutes in vacuum, the specific resistances thereof were measured by the four point probe method. In addition, under the same conditions as described above, a film was formed on the polycarbonate substrate having 120 mm in diameter and 3 µm in thickness. The coated film was completely peeled off and powdered, and the crystallization temperature was measured by DTA (Differential Thermal Analysis Method) under the conditions which temperature rose to at a rate of 10°C/min and argon gas was supplied at a rate of 200 ml/min. The results of the measurement are shown in Table 2. In addition, the amounts of the samples used for this measurement were all the same 20 mg. Here, the exothermic peak appearing in the vicinity of 150 to 350°C is regarded as the crystallization temperature.

**[Table 2]**

| Phase change recording film | | Composition (atom%) | | | | | Specific Resistance (Ω· cm) | Crystallization temperature (° C) |
|---|---|---|---|---|---|---|---|---|
| | | Ge | Sb | Al | Si | Te | | |
| The present invention | 1 | 21.30 | 21.39 | 0.12 | - | Balance | 5.22 X 10⁻² | 160.4 |
| | 2 | 21.00 | 21.34 | 0.18 | - | Balance | 5.94 X 10⁻² | 163.8 |
| | 3 | 20.13 | 21.32 | 0.49 | - | Balance | 7.69 X 10⁻² | 167.3 |
| | 4 | 20.03 | 21.17 | 0.79 | - | Balance | 8.32 X 10⁻² | 177.6 |
| | 5 | 20.80 | 20.96 | 1.94 | - | Balance | 9.54 X 10⁻² | 197.5 |
| | 6 | 19.65 | 20.79 | 2.92 | - | Balance | 1.12 X 10⁻¹ | 215.3 |
| | 7 | 17.44 | 20.50 | 3.96 | - | Balance | 1.65 X 10⁻¹ | 238.4 |
| | 8 | 20.22 | 21.37 | - | 0.11 | Balance | 5.63 X 10⁻² | 160.4 |
| | 9 | 21.21 | 21.30 | - | 0.16 | Balance | 6.25 X 10⁻² | 163.4 |
| | 10 | 21.15 | 21.19 | - | 0.42 | Balance | 8.08 X 10⁻² | 168.1 |
| | 11 | 20.02 | 21.18 | - | 0.90 | Balance | 9.86 X 10⁻² | 178.8 |
| | 12 | 19.83 | 20.92 | - | 1.89 | Balance | 1.14 X 10⁻¹ | 197.1 |
| | 13 | 19.71 | 20.76 | - | 2.85 | Balance | 1.49 X 10⁻¹ | 218.9 |
| | 14 | 20.37 | 20.45 | - | 3.83 | Balance | 1.93 X 10⁻¹ | 238.5 |
| | 15 | 19.64 | 20.80 | 0.90 | 1.89 | Balance | 1.22 X 10⁻¹ | 219.4 |
| | 16 | 19.58 | 20.76 | 1.95 | 0.82 | Balance | 1.06 X 10⁻¹ | 210.5 |
| | 17 | 20.15 | 20.92 | 4.4 | - | Balance | 1.87 X 10⁻¹ | 242.5 |
| | 18 | 20.68 | 20.02 | 6.3 | - | Balance | 2.25 X 10⁻¹ | 248.7 |
| | 19 | 19.23 | 20.52 | 7.9 | - | Balance | 2.51 X 10⁻¹ | 257.0 |
| | 20 | 19.54 | 20.34 | 9.6 | - | Balance | 2.87 X 10⁻¹ | 265.3 |
| | 21 | 19.32 | 19.06 | 10.5 | - | Balance | 3.01 X 10⁻¹ | 274.8 |
| | 22 | 19.30 | 19.45 | 12.4 | - | Balance | 3.30 X 10⁻¹ | 285.3 |
| | 23 | 20.17 | 20.65 | - | 4.5 | Balance | 2.04 X 10⁻¹ | 241.6 |
| | 24 | 20.65 | 20.41 | - | 5.0 | Balance | 2.15 X 10⁻¹ | 244.5 |
| | 25 | 21.12 | 21.54 | - | 6.3 | Balance | 2.24 X 10⁻¹ | 247.2 |
| | 26 | 21.39 | 21.82 | - | 7.5 | Balance | 2.78 X 10⁻¹ | 250.1 |
| | 27 | 21.14 | 21.86 | - | 8.0 | Balance | 2.91 X 10⁻¹ | 252.3 |
| | 28 | 21.54 | 21.37 | - | 8.7 | Balance | 3.18 X 10⁻¹ | 256.9 |
| | 29 | 20.76 | 21.58 | - | 10.6 | Balance | 3.94 X 10⁻¹ | 265.7 |
| | 30 | 21.04 | 21.37 | - | 12.1 | Balance | 4.56 X 10⁻¹ | 287.4 |
| | 31 | 20.65 | 20.54 | 0.3 | 0.1 | Balance | 6.54 X 10⁻² | 165.9 |
| | 32 | 21.63 | 22.01 | 1.0 | 0.1 | Balance | 9.07 X 10⁻² | 216.2 |
| | 33 | 20.94 | 21.71 | 0.8 | 4.1 | Balance | 2.02 X 10⁻¹ | 239.4 |
| | 34 | 21.32 | 21.57 | 5.6 | 0.9 | Balance | 2.86 X 10⁻¹ | 245.4 |
| | 35 | 21.02 | 21.52 | 3.2 | 5.80 | Balance | 3.04 X 10⁻¹ | 251.7 |
| | 36 | 21.12 | 21.94 | 7.5 | 3.6 | Balance | 3.12 X 10⁻¹ | 275.2 |
| Comparative | 1 | 20.25 | 21.39 | 0.04* | - | Balance | 3.62 X 10⁻² | 159.8 |
| | 2 | 18.18 | 18.88 | 14.65 * | - | Balance | 8.13 X 10⁻¹ | 350.7 |
| | 3 | 19.97 | 21.40 | - | 0.03* | Balance | 2.79 X 10⁻² | 159.3 |
| | 4 | 18.23 | 19.01 | - | 14.51 * | Balance | 1.07 X 10⁰ | 359.7 |
| | 5 | 14.05 * | 24.61 | 9.4 | - | Balance | 4.82 X 10⁻² | 268.9 |
| | 6 | 31.21 * | 20.38 | - | 9.1 | Balance | 4.69 X 10⁻² | 271.6 |
| | 7 | 23.39 | 14.0* | 2.5 | 4.4 | Balance | 3.55 X 10⁻² | 253.1 |
| | 8 | 19.55 | 26.1* | 5.6 | 0.5 | Balance | 3.76 X 10⁻² | 241.6 |
| Conventional 1 | | 20.40 | 21.60 | - | - | Balance | 1.05 X 10⁻² | 158.2 |

| | | | | | | | | |
|---|---|---|---|---|---|---|---|---|
| * mark means that the value deviates from the conditions of the present invention. | | | | | | | | |

From the result shown in Tables 1 and 2, it can be understood that the crystallized phase change recording films 1 to 36 according to the present invention which are obtained by sputtering with the targets 1 to 36 according to the present invention have a higher value in specific resistance than the conventional crystallized phase change recording film 1 which are obtained by sputtering with the conventional target 1. It can be understood that the comparative crystallized phase change recording films 1 to 8 which are obtained by sputtering with the comparative targets 1 to 8 with the composition which is out of the range of the present invention, have a lower specific resistance, or their crystallization temperatures rise too much.

### Example 2

Ge, Sb and Te were melted in an Ar gas atmosphere, and the melt was cast to form an alloy ingot. Thereafter, the ingot was crushed into alloy powder in an Ar atmosphere, having a particle size less than or equal to 250 µm.

A commercially available carbon powder is mixed with the alloy powder to make mixed powder. The mixed powder was hot-pressed in vacuum under a pressure of 146 Mpa at a temperature of 400°C to form a hot pressed body. The hot pressed body was ground by a cemented carbide bit at 200 rpm lathe revolution to obtain a disc having 125 mm in diameter and 5 mm in thickness. Targets 1 to 10 according to the present invention, comparative targets 1 and 2, and the conventional target 1 were prepared and the composition is shown in Table 3.

**[Table 3]**

| Target | | Composition (atom%) | | | |
|---|---|---|---|---|---|
| | | Ge | Sb | C | Te |
| The present invention | 1 | 21.98 | 21.98 | 0.25 | Balance |
| | 2 | 21.89 | 21.89 | 0.6 | Balance |
| | 3 | 21.82 | 21.82 | 0.9 | Balance |
| | 4 | 21.78 | 21.78 | 1.10 | Balance |
| | 5 | 21.56 | 21.56 | 2.15 | Balance |
| | 6 | 21.34 | 21.34 | 3.00 | Balance |
| | 7 | 20.90 | 20.90 | 5.00 | Balance |
| | 8 | 20.68 | 20.68 | 6.00 | Balance |
| | 9 | 20.65 | 20.65 | 7.00 | Balance |
| | 10 | 20.10 | 20.10 | 8.00 | Balance |
| Comparative | 1 | 21.99 | 21.99 | 0.1* | Balance |
| | 2 | 20.24 | 20.24 | 10.00* | Balance |
| Conventional 1 | | 22.20 | 22.20 | - | Balance |

| | | | | | |
|---|---|---|---|---|---|
| * mark means that the value deviates from the conditions of the present invention. | | | | | |

Each of targets 1 to 10 according to the present invention, comparative targets 1 and 2 and conventional target 1, was respectively bonded to a backing plate for cooling made of copper with an indium bonding material of purity: 99.999 weight %, which was loaded into a direct current magnetron sputtering apparatus, and the distance between a target and a substrate (an Si wafer formed with SiO₂ having 100 nm in thickness on the surface thereof) was set to be 70 mm. After vacuumizing was performed to reach an ultimate pressure of less than or equal to 5x10⁻⁵ Pa, an Ar gas was supplied to be a total pressure of 1.0 Pa. Under the conditions of
Substrate temperature: room temperature,
Power input: 50 W (0.4 W/cm²),
sputtering was carried out to obtain phase change recording films 1 to 10 according to the present invention, comparative phase change recording films 1 and 2 and a conventional phase change recording film 1 having the same thickness of 300 nm on the surface of the substrate.

The composition of the phase change recording films 1 to 10 according to the present invention, the comparative phase change recording films 1 and 2 and the conventional phase change recording film 1, were measured by EPMA (electron beam probe micro-analyzer), and the results are shown in Table 4. On the other hand, influence of C component introduced by surface absorption from the atmosphere was considered in the composition analysis by EPMA. Therefore, the value that the amount of carbon detected in the films which are separately formed by using the Ge-Sb-Te target to which C is not added (equivalent to amount of carbon adsorbed from the atmosphere) is deducted from the analysis value of each film, is regarded as the amount of carbon of each film. In addition, after the phase change recording films 1 to 10 according to the present invention, the comparative phase change recording films 1 and 2 and the conventional phase change recording film 1, were kept for crystallization at a temperature of 300°C for 5 minutes in vacuum, the specific resistances thereof were measured by the four point probe method. In addition, under the same conditions as described above, a film was formed on the polycarbonate substrate having 120 mm in diameter and 3 *µm* in thickness. The coated film was completely peeled off and powdered, and the crystallization temperature was measured by DTA (Differential Thermal Analysis Method) under the conditions which temperature rose to at a rate of 10°C/min and argon gas was supplied at a rate of 200 ml/min. The results of the measurement are shown in Table 4. In addition, the amounts of the samples used for this measurement were all the same 15 mg. the exothermic peak appearing in the vicinity of 150 to 350°C is regarded as the crystallization temperature.

**[Table 4]**

| Phase change recording film | | Composition (atom%) | | | | Specific Resistance (Ω·cm) | Crystallization temperature (°C) |
|---|---|---|---|---|---|---|---|
| | | Ge | Sb | C | Te | | |
| The present invention | 1 | 20.51 | 23.73 | 0.21 | Balance | 6.54 X 10⁻² | 163.4 |
| | 2 | 20.43 | 23.62 | 0.54 | Balance | 9.27 X 10⁻² | 171.4 |
| | 3 | 20.34 | 23.58 | 0.81 | Balance | 1.40 X 10⁻¹ | 178.2 |
| | 4 | 20.30 | 23.49 | 1.02 | Balance | 1.81 X 10⁻¹ | 182.9 |
| | 5 | 20.11 | 23.26 | 1.97 | Balance | 2.53 X 10⁻¹ | 207.5 |
| | 6 | 19.93 | 22.57 | 2.93 | Balance | 3.32 X 10⁻¹ | 234.3 |
| | 7 | 19.45 | 22.57 | 4.90 | Balance | 4.84 X 10⁻¹ | 254.5 |
| | 8 | 19.24 | 22.38 | 5.86 | Balance | 5.77 X 10⁻¹ | 263.2 |
| | 9 | 20.14 | 20.56 | 6.60 | Balance | 6.34 X 10⁻¹ | 284.4 |
| | 10 | 19.34 | 20.25 | 7.41 | Balance | 7.50 X 10⁻¹ | 292.8 |
| Comparative | 1 | 20.55 | 23.83 | 0.08* | Balance | 3.42 X 10⁻² | 161.2 |
| | 2 | 18.83 | 21.81 | 9.82* | Balance | 1.03 X 10⁰ | 330.0 |
| Conventional 1 | | 20.40 | 21.60 | - | Balance | 1.05 X 10⁻² | 158.2 |

| | | | | | | | |
|---|---|---|---|---|---|---|---|
| * mark means that the value deviates from the conditions of the present invention. | | | | | | | |

From the result shown in Tables 3 and 4, it can be understood that the crystallized phase change recording films 1 to 10 according to the present invention which are obtained by sputtering with the targets 1 to 10 according to the present invention have a higher value in specific resistance than the conventional crystallized phase change recording film 1 which are obtained by sputtering with the conventional target 1. It can be understood that the comparative crystallized phase change recording films 1 and 2 which are obtained by sputtering with the comparative targets 1 and 2 with the composition which is out of the range of the present invention, have a lower specific resistance, or their crystallization temperatures rise too much.

### Example 3

Ge, Sb, Te and B were melted in an Ar gas atmosphere, and the melt was cast to form an alloy ingot. Thereafter, the ingot was crushed into alloy powder in an Ar atmosphere, having a particle size less than or equal to 250 µm.

The alloy powder was hot-pressed in vacuum under a pressure of 146 Mpa at a temperature of 400°C to form a hot pressed body. The hot pressed body was ground by a cemented carbide bit at 200 rpm lathe revolution to obtain a disc having 125 mm in diameter and 5 mm in thickness. Targets 1 to 9 according to the present invention, comparative targets 1 and 2 and a conventional target 1, were prepared in this manner and the composition is shown in Table 5.

**[Table 5]**

| Target | | Composition (atom%) | | | |
|---|---|---|---|---|---|
| | | Ge | Sb | B | Te |
| The present invention | 1 | 22.16 | 22.16 | 0.25 | Balance |
| | 2 | 22.09 | 22.09 | 0.50 | Balance |
| | 3 | 21.98 | 21.98 | 1.00 | Balance |
| | 4 | 21.76 | 21.76 | 2.00 | Balance |
| | 5 | 21.53 | 21.53 | 3.00 | Balance |
| | 6 | 21.09 | 21.09 | 5.00 | Balance |
| | 7 | 20.42 | 20.42 | 8.00 | Balance |
| | 8 | 19.98 | 19.98 | 10.00 | Balance |
| | 9 | 19.54 | 19.54 | 12.00 | Balance |
| Comparative | 1 | 22.18 | 22.19 | 0.1* | Balance |
| | 2 | 18.87 | 18.87 | 15.00* | Balance |
| Conventional 1 | | 22.20 | 22.20 | - | Balance |

| | | | | | |
|---|---|---|---|---|---|
| * mark means that the value deviates from the conditions of the present invention. | | | | | |

Each of targets 1 to 9 according to the present invention, comparative targets 1 and 2 and conventional target 1, was bonded to a backing plate for cooling made of copper with an indium bonding material of purity: 99.999 weight %, which was loaded into a direct current magnetron sputtering apparatus, and the distance between a target and a substrate (an Si wafer formed with SiO₂ having 100 nm in thickness on the surface thereof) was set to be 70 mm. After vacuumizing was performed to reach an ultimate pressure of less than or equal to 5x10⁻⁵ Pa, an Ar gas was supplied to be a total pressure of 1.0 Pa. Under the conditions of
Substrate temperature: room temperature,
Power input: 50 W (0.4 W/cm²),
sputtering was carried out to obtain phase change recording films 1 to 9 according to the present invention, comparative phase change recording films 1 and 2 and a conventional phase change recording film 1 having thickness: 300 nm on the surface of the substrate. The composition of the phase change recording films 1 to 9 according to the present invention, the comparative phase change recording films 1 and 2 and the conventional phase change recording film 1, which are obtained in this way, are analyzed by ICP (inductively coupled plasma method), and the results are shown in Table 6. In addition, after the phase change recording films 1 to 9 according to the present invention, the comparative phase change recording films 1 and 2 and the conventional phase change recording film 1, were kept for crystallization at a temperature of 300° C for 5 minutes in vacuum, the specific resistance thereof were measured by the four point probe method. In addition, under the same conditions as described above, a film was formed on the polycarbonate substrate having 120 mm in diameter and 3 µm in thickness. The coated film was completely peeled off and powdered, and the crystallization temperature was measured by DTA (Differential Thermal Analysis Method) under the conditions which temperature rose to at a rate of 10°C/min and argon gas was supplied at a rate of 200 ml/min. The results of the measurement are shown in Table 6. In addition, the amounts of the samples used for this measurement were all the same 15 mg. Here, the exothermic peak appearing in the vicinity of 150 to 300°C is regarded as the crystallization temperature.

**[Table 6]**

| Phase change recording film | | Composition (atom%) | | | | Specific Resistance (Ω·cm) | Crystallization temperature (°C) |
|---|---|---|---|---|---|---|---|
| | | Ge | Sb | B | Te | | |
| The present invention | 1 | 22.44 | 23.16 | 0.21 | Balance | 5.08 X 10⁻² | 160.8 |
| | 2 | 20.41 | 23.10 | 0.46 | Balance | 5.54 X 10⁻² | 163.9 |
| | 3 | 22.26 | 22.96 | 0.98 | Balance | 6.13 X 10⁻² | 170.3 |
| | 4 | 22.01 | 22.74 | 1.87 | Balance | 6.89 X 10⁻² | 181.2 |
| | 5 | 21.84 | 22.49 | 2.94 | Balance | 8.62 X 10⁻² | 194.4 |
| | 6 | 21.40 | 22.07 | 4.89 | Balance | 1.02 X 10⁻¹ | 218.3 |
| | 7 | 20.74 | 21.38 | 7.58 | Balance | 1.23 X 10⁻¹ | 254.8 |
| | 8 | 20.31 | 20.88 | 9.88 | Balance | 2.31 X 10⁻¹ | 279.7 |
| | 9 | 19.91 | 20.50 | 11.74 | Balance | 3.65 X 10⁻¹ | 302.7 |
| Comparative | 1 | 22.49 | 23.22 | 0.04* | Balance | 3.25 X 10⁻² | 158.7 |
| | 2 | 19.05 | 19.72 | 14.96* | Balance | 5.68 X 10⁻¹ | 342.2 |
| Conventional 1 | | 20.40 | 21.60 | - | Balance | 1.05 X 10⁻² | 158.2 |

| | | | | | | | |
|---|---|---|---|---|---|---|---|
| * mark means that the value deviates from the conditions of the present invention. | | | | | | | |

From the result shown in Tables 5 and 6, it can be understood that the crystallized phase change recording films 1 to 9 according to the present invention which are obtained by sputtering with the targets 1 to 9 according to the present invention have a higher value in specific resistance than the conventional crystallized phase change recording film 1 which are obtained by sputtering with the conventional target 1. It can be understood that the comparative crystallized phase change recording films 1 and 2 which are obtained by sputtering with the comparative targets 1 and 2 with the composition which is out of the range of the present invention, have a lower specific resistance, or their crystallization temperatures rise too much.

### Example 4

Ge, Sb and Te were melted in an Ar gas atmosphere, and the melt was cast to form an alloy ingot. Thereafter, the ingot was crushed into alloy powder in an Ar atmosphere, having a particle size less than or equal to 100 µm. The alloy powder and powders of Ce, Pr, Nd, Pm, Sm, Eu, Gd, Tb, Dy, Ho, Er, Tm, Yb, Lu and La with the particle size of less than or equal to 100 µm, were mixed to make mixed powder.

The mixed powder was hot-pressed in vacuum under a pressure of 146 Mp at a temperature of 400°C to form a hot pressed body. The hot pressed body was ground by a cemented carbide bit at 200 rpm lathe revolution to obtain a disc having 125 mm in diameter and 5 mm in thickness. Targets 1 to 14 according to the present invention, and a conventional target 1, were prepared in this manner and the composition is shown in Table 7. In addition, specimens of sintered bodies which are made under the same conditions of making the targets 1 to 14 according to present invention and the conventional target 1 are made, and the three-point bending strength test to examine the strength of the specimens based on a prescribed condition in JISR1601 is performed, and the result is shown in Table 7.

Next, each of targets 1 to 14 according to the present invention, and conventional target 1, was bonded to a backing plate for cooling made of copper with an indium bonding material of the purity of 99.999 weight %, which was loaded into a direct current magnetron sputtering apparatus, and the distance between a target and a substrate (an Si wafer formed with SiO₂ having 100 nm in thickness on the surface thereof) was set to be 70 mm. After vacuumizing was performed to reach an ultimate pressure of less than or equal to 5x10⁻⁵Pa, an Ar gas was supplied to be a total pressure of 1.0 Pa. Under the conditions of
Substrate temperature: room temperature,
Power input: 50 W (0.4 W/cm²),
sputtering was carried out to obtain phase change recording films 1 to 14 according to the present invention, and a conventional phase change recording film 1 having the same thickness of 300 nm on the surface of the substrate, and at that time, the times of arcing during sputtering and crack of the targets after sputtering were observed. The result is shown in Table 7.

**[Table 7]**

| Target | | Composition (atom%) | | | | 3 Point bending strength (MPa) | Times of arcing | Target crack |
|---|---|---|---|---|---|---|---|---|
| | | Ge | Sb | Lanthanoid Element | Te | | | |
| The present invention | 1 | 21.87 | 21.87 | Ce:1.5 | Balance | 4.58 | 12 | None |
| | 2 | 21.87 | 21.87 | Pr:1.5 | Balance | 4.66 | 9 | None |
| | 3 | 21.87 | 21.87 | Nd:1.5 | Balance | 4.79 | 6 | None |
| | 4 | 21.87 | 21.87 | Pm:1.5 | Balance | 4.85 | 5 | None |
| | 5 | 21.87 | 21.87 | Sm:1.5 | Balance | 4.92 | 5 | None |
| | 6 | 21.87 | 21.87 | Eu:1.5 | Balance | 4.97 | 3 | None |
| | 7 | 21.87 | 21.87 | Gd:1.5 | Balance | 5.07 | 2 | None |
| | 8 | 21.87 | 21.87 | Tb:1.5 | Balance | 5.08 | 0 | None |
| | 9 | 21.87 | 21.87 | Dy:1.5 | Balance | 5.12 | 0 | None |
| | 10 | 21.87 | 21.87 | Ho:1.5 | Balance | 5.17 | 1 | None |
| | 11 | 21.87 | 21.87 | Er:1.5 | Balance | 5.21 | 4 | None |
| | 12 | 21.87 | 21.87 | Tm:1.5 | Balance | 5.25 | 2 | None |
| | 13 | 21.87 | 21.87 | Yb:1.5 | Balance | 5.33 | 0 | None |
| | 14 | 21.87 | 21.87 | Lu:1.5 | Balance | 5.43 | 3 | None |
| Conventional 1 | | 21.87 | 21.87 | La:1.5 | Balance | 3.13 | 139 | Yes |

From the result shown in Table 7, it can be understood that the three-point bending strength of the targets 1 to 14 having Ce, Pr, Nd, Pm, Sm, Eu, Gd, Tb, Dy, Ho, Er, Tm, Yb and Lu added thereto according to the present invention is higher than that of the conventional target 1 having La added thereto so that mechanical strength of the targets according to the present invention is better. Also, among the targets 1 to 4 according to the present invention, the bigger the atomic weight of the rare-earth elements to be added is, the higher the three-point bending strength is. It is considered the reason why the three-point bending strength of the conventional target 1 is low is due to characteristics, such as deliquescence or efflorescence, which are caused by atmospheric moisture absorbed by La existing in the targets.

In addition, it can be understood that the present invention targets 1 to 14 have fewer times of arcing, and a superior resistibility against crack of the targets, compared with the conventional target 1 having La added thereto.

The composition of the phase change recording films 1 to 14 according to the present invention, and the conventional phase change recording film 1, were measured by ICP (inductively coupled plasma method), and the results are shown in Table 8. In addition, after the phase change recording films 1 to 14 according to the present invention, and the conventional phase change recording film 1, were kept for crystallization at a temperature of 300° C for 5 minutes in vacuum, the specific resistances thereof were measured by the four point probe method. In addition, under the same conditions as described above, a film was formed on the polycarbonate substrate having 120 mm in diameter and 3 µm in thickness. The coated film was completely peeled off and powdered, and the crystallization temperature was measured by DTA (Differential Thermal Analysis Method) under the conditions which temperature rose to at a rate of 10°C/min and argon gas was supplied at a rate of 200 ml/min. The results of the measurement are shown in Table 8. In addition, the amounts of the samples used for this measurement were all the same 15 mg. Here, the exothermic peak appearing in the vicinity of 150 to 300°C is regarded as the crystallization temperature.

**[Table 8]**

| Phase change recording film | | Composition (atom%) | | | | Specific Resistance (Ω·cm) | Crystallization temperature (° C) |
|---|---|---|---|---|---|---|---|
| | | Ge | Sb | Lanthanoid Element | Te | | |
| The present invention | 1 | 22.17 | 22.46 | Ce:1.36 | Balance | 9.45 X 10⁻² | 172.5 |
| | 2 | 22.32 | 22.57 | Pr:1.44 | Balance | 9.88 X 10⁻² | 178.3 |
| | 3 | 22.27 | 22.59 | Nd:1.37 | Balance | 9.60 X 10⁻² | 173.6 |
| | 4 | 22.36 | 22.65 | Pm:1.45 | Balance | 1.12 X 10⁻¹ | 181.0 |
| | 5 | 22.38 | 22.71 | Sm:1.40 | Balance | 1.01 X 10⁻¹ | 177.3 |
| | 6 | 22.25 | 22.58 | Eu:1.39 | Balance | 9.93 X 10⁻² | 171.6 |
| | 7 | 22.30 | 22.57 | Gd:1.44 | Balance | 1.08 X 10⁻¹ | 179.8 |
| | 8 | 22.38 | 22.59 | Tb:1.45 | Balance | 9.12 X 10⁻² | 179.2 |
| | 9 | 22.20 | 22.54 | Dy:1.44 | Balance | 9.97 X 10⁻² | 176.0 |
| | 10 | 22.22 | 22.61 | Ho:1.41 | Balance | 1.06 X 10⁻¹ | 180.3 |
| | 11 | 22.30 | 22.60 | Er:1.46 | Balance | 1.03 X 10⁻¹ | 181.5 |
| | 12 | 22.23 | 22.54 | Tm:1.38 | Balance | 9.16 X 10⁻² | 173.7 |
| | 13 | 22.33 | 22.64 | Yb:1.42 | Balance | 9.37 X 10⁻² | 175.5 |
| | 14 | 22.28 | 22.49 | Lu:1.48 | Balance | 1.10 X 10⁻¹ | 182.7 |
| Conventional 1 | | 22.19 | 22.81 | La:1.43 | Balance | 9.89 X 10⁻² | 171.8 |

From the result shown in Table 8, it can be understood that the crystallized phase change recording films 1 to 14 according to the present invention which are obtained by sputtering with the targets 1 to 14 according to the present invention including the same total amount of 0.1 and 10% of at least one or two elements selected from the group consisting essentially of Ce, Pr, Nd, Pm, Sm, Eu, Gd, Tb, Dy, Ho, Er, Tm, Yb and Lu does not show substantial difference in the values of specific resistance and crystallization temperature compared with the conventional crystallized phase change recording film 1 including La which are obtained by sputtering with the conventional target 1 including La of same amount, and both are the phase change recording films of a good quality.

### Example 5

Ge, Sb and Te were melted in an Ar gas atmosphere, and the melt was cast to form an alloy ingot. Thereafter, the ingot was crushed into alloy powder in an Ar atmosphere, having a particle size less than or equal to 100 µm. The alloy powder and powders of Tb with the particle size of less than or equal to 100 µm, were mixed to make mixed powder. The mixed powder was hot-pressed in vacuum under a pressure of 146 Mpa at a temperature of 400°C to form makes the hot pressed body. The hot pressed body was ground by a cemented carbide bit at 200 rpm lathe revolution to obtain a disc having 125 mm in diameter and 5 mm in thickness. Targets 15 to 24 according to the present invention, and comparative targets 1 and 2, were prepared in this manner and the composition is shown in Table 9.

**[Table 9]**

| Target | | Composition(atom%) | | | |
|---|---|---|---|---|---|
| | | Ge | Sb | Tb | Te |
| The present invention | 15 | 22.18 | 22.18 | 0.15 | Balance |
| | 16 | 22.16 | 22.16 | 0.20 | Balance |
| | 17 | 22.09 | 22.09 | 0.50 | Balance |
| | 18 | 21.98 | 21.98 | 1.00 | Balance |
| | 19 | 21.87 | 21.87 | 1.50 | Balance |
| | 20 | 21.76 | 21.76 | 2.00 | Balance |
| | 21 | 21.53 | 21.53 | 3.00 | Balance |
| | 22 | 21.09 | 21.09 | 5.00 | Balance |
| | 23 | 20.65 | 20.65 | 7.00 | Balance |
| | 24 | 19.98 | 19.98 | 10.00 | Balance |
| Comparative | 1 | 22.19 | 22.19 | 0.05* | Balance |
| | 2 | 19.54 | 19.54 | 12.00* | Balance |

| | | | | | |
|---|---|---|---|---|---|
| * mark means that the value deviates from the conditions of the present invention. | | | | | |

Next, each of targets 15 to 24 according to the present invention, and comparative targets 1 and 2, was bonded to a backing plate for cooling made of copper with an indium bonding material of the purity of 99.999 weight %, which was loaded into a direct current magnetron sputtering apparatus, and the distance between a target and a substrate (an Si wafer formed with SiO₂ having 100 nm in thickness on the surface thereof) was set to be 70 mm. After vacuumizing was performed to reach an ultimate pressure of less than or equal to 5x10⁻⁵ Pa, an Ar gas was supplied to be a total pressure of 1.0 Pa. Under the conditions of
Substrate temperature: room temperature,
Power input: 50 W (0.4 W/cm²),
sputtering was carried out to obtain phase change recording films 15 to 24 according to the present invention, and phase change recording films 1 and 2 having the same thickness of 300 nm on the surface of the substrate.

The composition of the phase change recording films 15 to 24 according to the present invention, and the comparative phase change recording films 1 and 2 were measured by ICP (inductively coupled plasma method), and the results are shown in Table 10. In addition, after the phase change recording films 15 to 24 according to the present invention, and the comparative phase change recording films 1 and 2, were kept for crystallization at a temperature of 300° C for 5 minutes in vacuum, the specific resistances thereof were measured by the four point probe method. In addition, under the same conditions as described above, a film was formed on the polycarbonate substrate having 120 mm in diameter and 3 µm in thickness. The coated film was completely peeled off and powdered, and the crystallization temperature was measured by DTA (Differential Thermal Analysis Method) under the conditions which temperature rose to at a rate of 10° C/min and argon gas was supplied at a rate of 200 ml/min. The results of the measurement are shown in Table 10. In addition, the amounts of the samples used for this measurement were all the same 15 mg. Here, the exothermic peak appearing in the vicinity of 150 to 300°C is regarded as the crystallization temperature.

**[Table 10]**

| Phase change recording film | | Composition (atom%) | | | | Specific Resistance (Ω·cm) | Crystallization temperature (°C) |
|---|---|---|---|---|---|---|---|
| | | Ge | Sb | Tb | Te | | |
| The present invention | 15 | 23.02 | 23.13 | 0.11 | Balance | 5.21 X 10⁻² | 159.6 |
| | 16 | 22.95 | 23.08 | 0.17 | Balance | 5.89 X 10⁻² | 161.5 |
| | 17 | 22.83 | 22.97 | 0.46 | Balance | 6.86 X 10⁻² | 165.2 |
| | 18 | 22.71 | 22.88 | 0.92 | Balance | 8.65 X 10⁻² | 172.2 |
| | 19 | 22.38 | 22.59 | 1.45 | Balance | 9.12 X 10⁻² | 179.2 |
| | 20 | 22.21 | 22.45 | 1.89 | Balance | 1.16 X 10⁻¹ | 188.2 |
| | 21 | 21.97 | 22.27 | 2.94 | Balance | 2.85 X 10⁻¹ | 200.2 |
| | 22 | 21.62 | 21.81 | 4.88 | Balance | 6.37 X 10⁻¹ | 228.2 |
| | 23 | 21.22 | 21.37 | 6.84 | Balance | 5.32 X 10⁰ | 256.2 |
| | 24 | 20.56 | 20.90 | 9.92 | Balance | 2.10 X 10¹ | 298.2 |
| Comparative | 1 | 22.72 | 22.98 | 0.03* | Balance | 3.64 X 10⁻² | 158.9 |
| | 2 | 20.08 | 20.27 | 11.86* | Balance | 5.08 X 10¹ | 326.2 |

| | | | | | | | |
|---|---|---|---|---|---|---|---|
| * mark means that the value deviates from the conditions of the present invention. | | | | | | | |

### Example 6

Ge, Sb and Te were melted in an Ar gas atmosphere, and the melt was cast to form an alloy ingot. Thereafter, the ingot was crushed into alloy powder in an Ar atmosphere, having a particle size less than or equal to 100 µm. The alloy powder and powders of Dy with the particle size of less than or equal to 100 µm, were mixed to make mixed powder. The mixed powder was hot-pressed in vacuum a pressure of 146 Mpa at a temperature of 400°C to form a hot pressed body. The hot pressed body was ground by a cemented carbide bit at 200 rpm lathe revolution to obtain a disc having 125 mm in diameter and 5 mm in thickness. Targets 25 to 34 according to the present invention, and comparative targets 3 and 4 were prepared and the composition is shown in Table 11.

**[Table 11]**

| Target | | Composition (atom%) | | | |
|---|---|---|---|---|---|
| | | Ge | Sb | Dy | Te |
| The present invention | 25 | 22.18 | 22.18 | 0.15 | Balance |
| | 26 | 22.16 | 22.16 | 0.20 | Balance |
| | 27 | 22.09 | 22.09 | 0.50 | Balance |
| | 28 | 21.98 | 21.98 | 1.00 | Balance |
| | 29 | 21.87 | 21.87 | 1.50 | Balance |
| | 30 | 21.76 | 21.76 | 2.00 | Balance |
| | 31 | 21.53 | 21.53 | 3.00 | Balance |
| | 32 | 21.09 | 21.09 | 5.00 | Balance |
| | 33 | 20.65 | 20.65 | 7.00 | Balance |
| | 34 | 19.98 | 19.98 | 10.00 | Balance |
| Comparative | 3 | 22.19 | 22.19 | 0.05* | Balance |
| | 4 | 19.54 | 19.54 | 12.00* | Balance |

| | | | | | |
|---|---|---|---|---|---|
| * mark means that the value deviates from the conditions of the present invention. | | | | | |

Next, each of targets 25 to 34 according to the present invention, and comparative targets 3 and 4, was bonded to a backing plate for cooling made of copper with an indium bonding material of the purity of 99.999 weight %, which was loaded into a direct current magnetron sputtering apparatus, and the distance between a target and a substrate (an Si wafer formed with SiO₂ having 100 nm in thickness on the surface thereof) was set to be 70 mm. After vacuumizing was performed to reach an ultimate pressure of less than or equal to 5x10⁻⁵Pa, an Ar gas was supplied to be a total pressure of 1.0 Pa. Under the conditions of
Substrate temperature: room temperature,
Power input: 50 W (0.4 W/cm²),
sputtering was carried out to obtain phase change recording films 25 to 34 according to the present invention, and phase change recording films 3 and 4 having the same thickness of 300 nm on the surface of the substrate.

The composition of the phase change recording films 25 to 34 according to the present invention, and comparative phase change recording films 3 and 4, which are obtained in this way, were measured by ICP (inductively coupled plasma method), and the results are shown in Table 12. In addition, after the phase change recording films 25 to 34 according to the present invention, and the comparative phase change recording films 3 and 4, were kept for crystallization at a temperature of 300° C for 5 minutes in vacuum, the specific resistances thereof were measured by the four point probe method. In addition, under the same conditions as described above, a film was formed on the polycarbonate substrate having 120 mm in diameter and 3 µm in thickness. The coated film was completely peeled off and powdered, and the crystallization temperature was measured by DTA (Differential Thermal Analysis Method) under the conditions which temperature rose to at a rate of 10°C/min and argon gas was supplied at a rate of 200 ml/min. The results of the measurement are shown in Table 12. In addition, the amounts of the samples used for this measurement were all the same 15 mg. Here, the exothermic peak appearing in the vicinity of 150 to 300°C is regarded as the crystallization temperature.

**[Table 12]**

| Phase change recording film | | Composition (atom%) | | | | Specific Resistance (Ω·cm) | Crystallization temperature °C) |
|---|---|---|---|---|---|---|---|
| | | Ge | Sb | Dy | Te | | |
| The present invention | 25 | 22.71 | 23.25 | 0.14 | Balance | 5.40 X 10⁻² | 159.4 |
| | 26 | 22.85 | 23.17 | 0.18 | Balance | 6.04 X 10⁻² | 160.6 |
| | 27 | 22.58 | 22.92 | 0.48 | Balance | 7.12 X 10⁻² | 164.1 |
| | 28 | 22.36 | 22.79 | 0.96 | Balance | 8.90 X 10⁻² | 170.1 |
| | 29 | 22.20 | 22.54 | 1.44 | Balance | 9.97 X 10⁻² | 176.0 |
| | 30 | 21.99 | 22.18 | 1.90 | Balance | 1.28 X 10⁻¹ | 181.9 |
| | 31 | 21.85 | 21.97 | 2.89 | Balance | 8.57 X 10⁻¹ | 193.8 |
| | 32 | 21.46 | 21.66 | 4.93 | Balance | 7.59 X 10⁰ | 217.6 |
| | 33 | 20.94 | 21.23 | 6.95 | Balance | 2.71 X 10¹ | 241.3 |
| | 34 | 20.41 | 20.72 | 9.92 | Balance | 4.85 X 10¹ | 276.9 |
| Comparative | 3 | 22.50 | 22.74 | 0.03* | Balance | 3.78 X 10⁻² | 158.9 |
| | 4 | 19.87 | 20.05 | 11.91* | Balance | 7.72 X 10¹ | 326.2 |

| | | | | | | | |
|---|---|---|---|---|---|---|---|
| * mark means that the value deviates from the conditions of the present invention. | | | | | | | |

From the result shown in Tables 9 and 10 in Example 5 and as shown in Tables 11 and 12 in Example 6, it can be understood that the crystallized phase change recording films 15 to 34 according to the present invention which are obtained by sputtering using the targets 15 to 34 according to the present invention including 1 to 10% of Tb or Dy have a higher specific resistance compared with the comparative crystallized phase change recording films 1 or 3 which are obtained by sputtering using the comparative targets 1 or 3 including less than 1% of Tb or Dy, and in addition, it is not preferable because the crystallization temperature of the comparative crystallized phase change recording films 2 or 4 which are obtained by sputtering using the comparative targets 2 or 4 including more than 10% of Tb or Dy, increase too much. Therefore, it can be understood that the content of Tb or Dy is preferably in the range of 1 to 10%.

In addition, the same result is also obtained in case that the film includes a total of 0.1 and 10% of at least one or two elements selected from the group consisting essentially of Ce, Pr, Nd, Pm, Sm, Eu, Gd, Tb, Dy, Ho, Er, Tm, Yb and Lu aside from Tb and Dy.

As described above, according to the present invention, an appropriately high resistance value can be obtained and a current value at the time of writing and erasing operation can be reduced, which contribute to low power consumption and to micro-fabrication. Further, characteristic of a phase change type non-volatile memory film can be improved and the manufacturing cost can be reduced. With all the merits described above, the present invention may contribute very much to the development of new semiconductor memory industry.

## Claims

1. A phase change recording film having high electrical resistance, wherein the phase change recording film has a composition comprising, by atom%
(hereinafter, % means atom%):
15 to 30% of Ge;
15 to 25% of Sb;
a total of 0.1 to 13% of one or two elements selected from the group consisting essentially of Al and Si; and
the balance of Te and inevitable impurities.

2. A phase change recording film having high electrical resistance according to claim 1, wherein the specific resistance value measured by the four point probe method after crystallization is about 5x10⁻² to 5x10¹ Ω·cm.

3. A sputtering target for forming the phase change recording film having high electrical resistance according to claim 1 or 2, wherein the phase change recording film has a composition comprising:
15 to 30% of Ge;
15 to 25% of Sb;
a total of 0.1 to 13% of one or two elements selected from the group consisting essentially of Al and Si; and
the balance of Te and inevitable impurities.

4. A phase change recording film having high electrical resistance, wherein the phase change recording film has a composition comprising, by atom%
(hereinafter, % means atom%):
15 to 30% of Ge;
15 to 30% of Sb;
0.2 to 8% of C; and
the balance of Te and inevitable impurities.

5. A phase change recording film having high electrical resistance according to claim 4, wherein the specific resistance value measured by the four point probe method after crystallization is about 5x10⁻² to 5x10¹ Ω·cm.

6. A sputtering target for forming the phase change recording film having high electrical resistance according to claim 4 or 5, wherein the phase change recording film has a composition comprising:
15 to 30% of Ge;
15 to 30% of Sb;
0.2 to 8% of C; and
the balance of Te and inevitable impurities.

7. A phase change recording film having high electrical resistance, wherein the phase change recording film has a composition comprising, by atom%
(hereinafter, % means atom%):
15 to 30% of Ge;
15 to 30% of Sb;
0.2 to 12% of B; and
the balance of Te and inevitable impurities.

8. A phase change recording film having high electrical resistance according to claim 7, wherein the specific resistance value measured by the four point probe method after crystallization is about 5x10⁻² to 5x10¹ Ω·cm.

9. A sputtering target for forming the phase change recording film having high electrical resistance according to claim 7 or 8, wherein the phase change recording film has a composition comprising:
15 to 30% of Ge;
15 to 30% of Sb;
0.2 to 12% of B;
and the balance of Te and inevitable impurities.

10. A sputtering target for forming the phase change recording film having high electrical resistance, wherein the phase change recording film has a composition comprising:
15 to 30% of Ge;
15 to 30% of Sb;
a total of 0.1 to 10% of at least one or two elements selected from the group consisting essentially of Ce, Pr, Nd, Pm, Sm, Eu, Gd, Tb, Dy, Ho, Er, Tm, Yb and Lu, and the balance of Te and inevitable impurities.

11. A phase change recording film having high electrical resistance, wherein the phase change recording film has a composition comprising:
15 to 30% of Ge;
15 to 30% of Sb;
a total of 0.1 to 10% of at least one or two elements selected from the group consisting essentially of Ce, Pr, Nd, Pm, Sm, Eu, Gd, Tb, Dy, Ho, Er, Tm, Yb and Lu; and
the balance of Te and inevitable impurities.

12. A phase change recording film having high electrical resistance according to claim 11, wherein the specific resistance value measured by the four point probe method after crystallization is 5x10⁻² to 5x10¹ Ω·cm.
